Europäisches Patentamt

European Patent Office

Office européen des brevets

(11) Numéro de publication: **0 406 066 A1**

## DEMANDE DE BREVET EUROPEEN

(21) Numéro de dépôt: 90401747.2

(22) Date de dépôt: 20.06.90

(51) Int. Cl.⁵: **G01R 33/035**

(30) Priorité: 20.06.89 FR 8908207

(43) Date de publication de la demande:
02.01.91 Bulletin 91/01

(84) Etats contractants désignés:
BE CH DE ES GB GR IT LI NL SE

(71) Demandeur: FRAMATOME
Tour Fiat 1, Place de la Coupole
F-92400 Courbevoie(FR)

Demandeur: CENTRE NATIONAL DE LA
RECHERCHE SCIENTIFIQUE (CNRS)
15, Quai Anatole France
F-75008 Paris(FR)

(72) Inventeur: Meyer, Jacques
3 Rue René Brulay
F-78500 Sartrouville(FR)
Inventeur: Bret, Jean-Louis
60 Rue de la Liberté
F-38180 Seyssins(FR)
Inventeur: Chaussy, Jacques
20 Allée François Vilon
F-38130 Echirolles(FR)
Inventeur: Gandit, Philippe
Chemin le Devier St Ligier du Moucherotte
F-38250 Villars de Lens(FR)
Inventeur: Pannetier, Bernard
17 rue des Violettes
F-38100 Grenoble(FR)

(74) Mandataire: Moncheny, Michel et al
c/o Cabinet Lavoix 2 Place d'Estienne
d'Orves
F-75441 Paris Cedex 09(FR)

(54) **Procédé et dispositif de mesure d'un champ magnétique.**

(57) Ce dispositif de mesure, du type comportant un corps (4) en matériau supraconducteur, placé dans le champ magnétique à mesurer, des moyens (5, 6, 7) adaptés pour faire passer successivement la température du corps (4) en matériau supraconducteur au-dessus et au-dessous de sa température de transition supraconductrice et donc faire passer le corps d'un premier état dans lequel il est perméable aux lignes de champ, lorsque sa température est supérieure à sa température de transition supraconductrice, dans un second état dans lequel il est imperméable aux lignes de champ, lorsque sa température est inférieure à sa température de transition supraconductrice, et inversement, de manière à engendrer des variations de champ magnétique dans le voisinage du corps, et des moyens (10, 11) de détection de ces variations de champ, est caractérisé en ce qu'il comporte des moyens (10,11)de détermination du champ à partir de ces variations.

FIG.2

La présente invention concerne un procédé et un dispositif de mesure d'un champ magnétique, à l'aide d'un corps en matériau supraconducteur placé dans le champ magnétique à mesurer.

On connaît déjà dans l'état de la technique un certain nombre de dispositifs de ce type comme, par exemple, des interféromètres quantiques supraconducteurs (Superconducting Quantum Interference Device "SQUID"). Le fonctionnement de ces interféromètres est basé sur des phénomènes liés à la supraconductivité des matériaux utilisés, comme la quantification du flux magnétique et les effets JOSEPHSON.

En effet, si on refroidit un anneau de matériau métallique jusqu'au passage de celui-ci à l'état supraconducteur, en présence d'un champ magnétique, puis que l'on coupe ce champ, on note que le flux magnétique, quantité représentant le produit du champ dans l'anneau par la surface de ce dernier, reste piégé dans l'anneau. Le flux est en effet maintenu par un courant de supraconduction qui a pris naissance dans l'anneau pour s'opposer aux variations de flux, d'après la loi de LENZ, et y persiste de façon permanente. Ainsi, le courant induit dans l'anneau est une représentation du flux et donc du champ magnétique que l'on désire déterminer. La mesure de ce courant permet donc de déduire le champ magnétique. Cependant, cette mesure présente un certain nombre d'inconvénients.

En effet, dans un interféromètre dit à effet JOSEPHSON continu l'anneau supraconducteur comporte deux barrières. Par application d'un champ magnétique, celles-ci deviennent résistives et il apparaît une différence de potentiel entre les parties de l'anneau séparées par les barrières. La différence de potentiel est alors mesurable et permet de déterminer le flux magnétique.

Dans les interféromètres dits à effet JOSEPHSON alternatif, l'anneau ne présente qu'une seule barrière et est de ce fait plus facile à fabriquer. Cependant, il est plus difficile de détecter le passage à l'état résistif d une barrière et ce problème est résolu en mettant à profit la faible inductance de l'anneau. Celui-ci est en effet couplé par induction mutuelle à un circuit oscillant extérieur qui y induit un courant alternatif à des fréquences allant d'une dizaine de MHz jusqu'aux hyperfréquences. Les variations du courant dans l'anneau, induites par le champ magnétique à mesurer, se traduisent alors par des variations du niveau d'oscillation du circuit extérieur, variations que l'on peut mesurer pour déterminer le champ magnétique.

On conçoit que ce type d'interféromètres quantiques supraconducteurs utilisant l'effet JOSEPHSON ne permettent de détecter que des variations du flux magnétique. Ces dispositifs très performants exigent, pour les élaborer, la maîtrise de techniques très évoluées et par là-même très onéreuses. En effet, leur fabrication est extrêmement délicate dans la mesure où il est nécessaire de réaliser des jonctions tunnels constituant les barrières décrites précédemment et d'utiliser une électronique de mesure associée très complexe.

Pour plus de renseignements sur ces interféromètres, on se reportera aux articles publiés dans les revues "La Recherche" n° 133, Mai 1982, pages 604 à 613 et "Pour la Science" n° 138, Avril 1989, pages 52 à 61.

On connaît également d'après les documents JP-A-55-37978 et JP-A-55-37979 des dispositifs de mesure de champ magnétique utilisant des barreaux de matériau supraconducteur. Dans ces dispositifs, la mesure est réalisée en utilisant la relation champ magnétique extérieur/courant critique qui circule dans le barreau. Le courant induit dans une bobine de lecture à l'instant de la transition supraconductivité/non supracondutivité est utilisé pour détecter ce passage et la mesure du champ est obtenue par la lecture du courant critique à l'instant de cette transition, la relation champ/courant étant supposée connue au préalable.

On conçoit qu'une telle mesure n'est pas très simple à réaliser à partir du courant critique et que l'on doit tout d'abord déterminer la relation champ/courant et ensuite effectuer un étalonnage de ces dispositifs.

Le but de l'invention est donc de résoudre les problèmes évoqués précédemment en proposant un procédé et un dispositif de mesure qui soient simples,fiables et précis, permettant par exemple de mesurer de très faibles valeurs de champ magnétique, de l'ordre de $10^{-14}$ à $10^{-15}$ TESLA, qui permettent d'utiliser tout matériau supraconducteur, quelle que soit sa température de transition supraconductrice, d'opérer une mesure absolue d'un champ magnétique et enfin d'utiliser une électronique de traitement classique.

A cet effet, l'invention a pour objet un procédé de mesure d'un champ magnétique, à l'aide d'un corps en matériau supraconducteur, placé dans le champ magnétique à mesurer, dans lequel on fait passer successivement la température du corps en matériau supraconducteur au-dessus et au-dessous de sa température de transition supraconductrice et donc on fait passer le corps d'un premier état dans lequel il est perméable aux lignes de champ, lorsque sa tempéra ture est supérieure à sa température de transition supraconductrice, dans un second état dans lequel il est imperméable aux lignes de champ, lorsque sa température est inférieure à sa température de transition supraconductrice, et inversement, de manière à engendrer des variations de champ magnétique dans le voisinage du corps, à détecter ces variations de champ, caractérisé en ce qu'on détermine le champ à partir de ces variations.

Selon un autre aspect, l'invention a également pour objet un dispositif de mesure pour la mise en oeuvre du procédé tel que décrit précédemment, du type comportant un corps en matériau supraconducteur, placé dans le champ magnétique à mesurer, des moyens adaptés pour faire passer successivement la température du corps en matériau supraconducteur au-dessus et au-dessous de sa température de transition supraconductrice et donc faire passer le corps d'un premier état dans lequel il est perméable aux lignes de champ, lorsque sa température est supérieure à sa température de transition supraconductrice, dans un second état dans lequel·il est imperméable aux lignes de champ, lorsque sa température est inférieure à sa température de transition supraconductrice, et inversement, de manière à engendrer des variations de champ magnétique dans le voisinage du corps, et des moyens de détection de ces variations de champ, caractérisé en ce qu'il comporte des moyens de détermination du champ à partir de ces variations.

Avantageusement, le corps est disposé dans un cryostat, à une température inférieure à sa température de transition supraconductrice, et le dispositif comporte des moyens de chauffage du corps pour faire passer sa température au- dessus de sa tempéra ture de transition supraconductrice.

Avantageusement également, les moyens de chauffage comprennent des moyens de génération d'un rayonnement optique disposés à une extrémité d'un guide optique, à l'extérieur du cryostat, l'autre extrémite de ce guide étant disposée en regard du corps dans le cryostat.

Le corps peut être constitué par une couche mince de matériau supraconducteur disposée sur un substrat de matériau isolant, perpendiculairement aux lignes de champ et il peut se présenter sous la forme d'un disque.

Les moyens de détection des variations du champ magnétique comprennent au moins une spire de matériau conducteur ou supraconducteur, disposée autour du corps et les moyens de détermination du champ comprennent des moyens de mesure d'une tension engendrée aux bornes de cette spire, lors du passage du matériau supraconducteur entre ses deux états, cette tension étant proportionnelle au champ à mesurer.

L'invention sera mieux comprise à l'aide de la description qui va suivre donnée uniquement à titre d'exemple et faite en se référant aux dessins annexés sur lesquels :

- les figure 1A et 1B illustrent le principe de fonctionnement d'un procédé et d'un dispositif de mesure selon l'invention ;
- la figure 2 représente un schéma d'un dispositif pour la mise en oeuvre d'un procédé selon l'invention,
- la figure 3 représente une vue de dessus d'un premier mode de réalisation d'un corps en matériau supraconducteur entrant dans la constitution d'un dispositif selon l'invention,
- la figure 4 représente une vue en perspective et en coupe d'un second mode de réalisation d'un corps en matériau supraconducteur entrant dans la constitution d'un dispositif selon l'invention,
- la figure 5 représente un schéma synoptique d'un circuit électronique de traitement de signaux entrant dans la constitution d'un dispositif selon l'invention, et
- la figure 6 représente des signaux de sortie de moyens de détection entrant dans la constitution d'un dispositif selon l'invention.

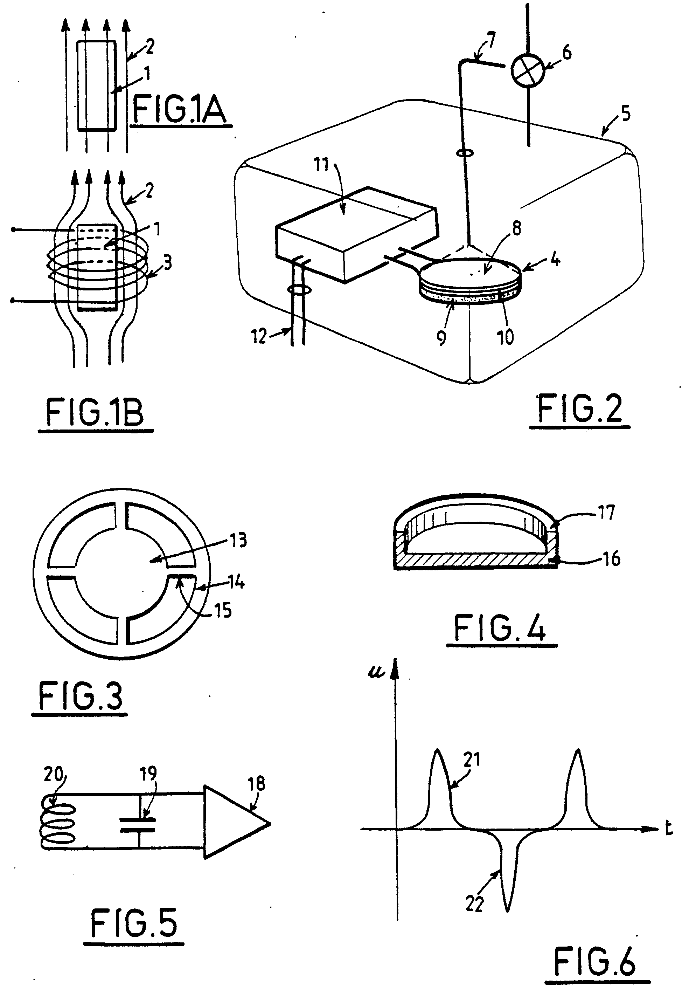

Comme on peut le voir sur les figures 1A et 1B qui illustrent un procédé de mesure d'un champ magnétique, selon l'invention, celui-ci met en oeuvre un corps en matériau supraconducteur 1 placé dans le champ magnétique à mesurer. Les lignes de champ sont illustrées par les flèches 2 sur ces figures.

Comme cela est représenté sur la figure 1A, tant que la température du corps en matériau supraconducteur est supérieure à sa température de transition supraconductrice, ce corps est dans un premier état dans lequel il est perméable aux lignes de champ. Le corps en matériau supraconducteur se comporte alors comme un corps en matériau métallique et le champ est régulier.

Par contre, lorsque la température du corps en matériau supraconducteur est inférieure à sa température de transition supraconductrice, ce corps passe du premier état décrit précédemment dans un second état dans lequel il devient imperméable aux lignes de champ magnétique et repousse celles-ci, comme cela est représenté la figure 1B.

Ce passage du matériau supraconducteur du premier état dans le second état, engendre alors des variations de champ magnétique dans le voisinage du corps et il est possible, grâce à des moyens de détection 3 constitués par exemple par au moins une spire de matériau conducteur ou supraconducteur, de détecter ces variations de champ pour en déterminer le champ. En effet, la variation de champ magnétique au voisinage du corps, induit dans la spire, d'après la loi de LENZ, un signal proportionnel à la variation de champ et donc au champ magnétique appliqué, tant que l'amplitude de celui-ci est inférieure à un seuil appelé champ critique du matériau supraconducteur.

Les variations de champ induisent en effet une tension aux bornes de la spire, cette tension étant proportionnelle aux variations de champ et donc au champ et permet de déterminer ce dernier.

En faisant passer successivement la température du corps en matériau supraconducteur au-dessus et au-dessous de sa température de transition supraconductrice, on obtient alors aux bornes de la spire un signal présentant des pics de tension dont l'amplitude est représentative du champ, comme cela sera décrit plus en détail par la suite.

Ce procédé peut être mis en oeuvre par un dispositif tel que celui représenté sur la figure 2, dans lequel un corps 4 en matériau supraconducteur est disposé dans un cryostat 5, à une température inférieure à la température de transition supraconductrice de celui-ci, par exemple à 4° K (- 269° C) ou plus, en fonction du matériau supraconducteur utilisé. Le matériau supraconducteur est alors imperméable aux lignes de champ.

Le dispositif comporte également des moyens de chauffage 6 du corps pour faire passer sa température au-dessus de sa température de transition supra conductrice. Ces moyens de chauffage comprennent avantageusement des moyens de génération d'un rayonnement optique comme par exemple une diode laser ou une diode électroluminescente. Ces moyens peuvent être disposés à l'extérieur du cryostat 5, à une extrémité d'un guide optique 7 constitué par exemple par une fibre optique dont l'autre extrémité est disposée en regard du corps en matériau supraconducteur 4 dans le cryostat. Ces moyens de chauffage sont activés par exemple séquentiellement pour faire passer la température du corps en matériau supraconducteur au-dessus de sa température de transition supraconductrice et lui faire changer d'état pour engendrer des variations de champ permettant la détermination de celui-ci, comme expliqué précédemment.

Comme cela est représenté sur cette figure, le corps en matériau supraconducteur peut être constitué par une couche mince de matériau supraconducteur 8 disposée sur un substrat de matériau isolant 9, perpendiculairement aux lignes de champ.

Une spire 10 de matériau conducteur ou supraconducteur, constituant les moyens de détection des variations de champ dans le voisinage du corps, est également disposée autour du corps en matériau supraconducteur et est reliée à des moyens de mesure 11 d'une tension engendrée aux bornes de cette spire, par la variation de champ lors du passage du matériau supraconducteur entre ses deux états.

Ainsi qu'on l'a mentionné précédemment, cette tension est proportionnelle au champ à mesurer et les moyens de détermination peuvent être constitués par tous moyens de mesure de très basse tension appropriés utilisant par exemple des hâcheurs et pouvant être constitués par des circuits électroniques fonc tionnant à très basse température, disposés dans une enceinte à l'intérieur du cryostat. La sortie 12 de ces moyens délivre une représentation du champ.

Comme on peut le voir sur les figures 3 et 4, le corps en matériau supraconducteur peut se présenter sous la forme d'un disque. La couche de matériau supraconducteur peut présenter une épaisseur comprise entre $10^{-2}$ μm et 10 μm, tandis que le substrat peut présenter une épaisseur comprise entre 0,1 μm et 10 μm.

Sur la figure 3, on a représenté un premier mode de réalisation de ce corps dans lequel celui-ci est constitué par un disque 13 autour duquel est disposé un anneau 14 présentant une épaisseur supérieure à celle du disque 13 et étant relié à celui-ci par des ponts 15.

Bien entendu, et comme cela est représenté sur la figure 4, le corps peut également se présenter sous la forme d'un disque 16 présentant une nervure périphérique 17 en saillie sur au moins l'une de ses faces.

Il est à noter que le disque peut présenter un diamètre compris entre 1 mm et 30 mm.

Le substrat peut, quant à lui, être constitué par un support mécanique en matériau à très faible conductibilité thermique et très faible densité.

Ceci permet de réduire au maximum la masse de matière mise en jeu durant la modulation thermique, c'est-à-dire le passage du corps au-dessus et au-dessous de sa température de transition supraconductrice afin de permettre un fonctionnement du dispositif à une fréquence maximale permettant d'améliorer sa précision et sa sensibilité, celles-ci étant directement proportionnelles à la fréquence de travail.

Sur la figure 5, on a représenté un schéma synoptique illustrant le circuit électronique de mesu-re de la tension aux bornes de la spire de détection. Ce circuit est constitué d'un amplificateur 18 et d'un circuit de détection comprenant un condensateur 19 et une inductance 20 en parallèle sur les entrées de l'amplificateur. L'amplificateur comporte par exemple des transistors à effet de champ dont l'énergie de bruit est très faible lorsqu'ils sont placés à basse température. Le circuit de détection comporte, quant à lui, l'inductance 20 mentionnée précédemment et est formée par exemple par la spire de matériau conducteur ou supraconducteur constituant les moyens de détection décrits précédemment et d'un condensateur en parallèle 19, tenant compte de la capacité parasite d'entrée des transistors à effet de champ de l'amplificateur. La fréquence de fonctionnement du dispositif est choisie pour obtenir les conditions de résonance du circuit et le plus grand facteur de surtension.

Bien entendu, tous autres moyens de mesure du signal représentatif du champ dans la spire peuvent être envisagés.

Sur la figure 6, on a représenté un exemple de signal de sortie des moyens de détection des variations de champ. Ce signal de sortie comporte des pics de tension par exemple 21 et 22 correspondant au passage du corps en matériau supraconducteur d'un état dans l'autre et inversement.

On conçoit donc que le procédé et le dispositif selon l'invention permettent d'obtenir des mesures absolues d'un champ magnétique en utilisant une électronique classique et tout matériau supraconducteur approprié.

Par ailleurs, la construction de tels dispsitifs est extrêmement simplifiée par rapport aux dispositifs à effet JOSEPHSON du fait de l'utilisation d'un disque supraconducteur en couche mince. Ce disque est associé à un substrat de capacité calorifique la plus faible possible permettant une fréquence de travail élevée, et l'obtention de la commutation du matériau supraconducteur par rayonnement optique, éliminant tout couplage parasite.

Cette couche mince de matériau supraconducteur peut être obtenue selon les techniques de fabrication classiques, ce qui permet d'obtenir des dispositifs de mesure de champ à prix réduit par rapport aux dispositifs à effet JOSEPHSON connus.

Le dispositif selon l'invention peut être utilisé dans de nombreuses applications. Ainsi par exemple, on peut l'utiliser dans :
- des applications médicales par exemple pour la mesure et le suivi de la propagation des lignes de champ magnétique au niveau du cerveau ou d'autres parties du corps humain,
- des applications de contrôles non destructifs par exemple pour détecter des microfissures for-mées à la suite de la fatigue des matériaux, notamment pour des composants nucléaires, des structures d'aéronefs, etc... ,
- des applications militaires par exemple pour la recherche et la détection d'objets sousmarins,
- des applications de recherches géologiques et minières.

## Revendications

1.- Procédé de mesure d'un champ magnétique, à l'aide d'un corps (1 ; 4) en matériau supraconducteur, placé dans le champ magnétique à mesurer, dans lequel on fait passer successivement la température du corps en matériau supraconducteur au-dessus et au-dessous de sa température de transition supraconductrice et donc on fait passer le corps d'un premier état dans lequel il est perméable aux lignes de champ, lorsque sa température est supérieure à sa température de transition supraconductrice, dans un second état dans lequel il est imperméable aux lignes de champ, lorsque sa température est inférieure à sa température de transition supraconductrice, et inversement, de manière à engendrer des variations de champ magnétique dans le voisinage du corps, à détecter ces variations de champ, caractérisé en ce qu'on détermine le champ à partir de ces variations.

2.- Dispositif de mesure pour la mise en oeuvre d'un procédé selon la revendication 1, du type comportant un corps (1 ; 4) en matériau supraconducteur, placé dans le champ magnétique à mesurer, des moyens (5, 6, 7) adaptés pour faire passer successivement la température du corps en matériau supraconducteur au-dessus et au-dessous de sa température de transition supraconductrice et donc faire passer le corps d'un premier état dans lequel il est perméable aux lignes de champ, lorsque sa température est supérieure à sa température de transition supraconductrice, dans un second état dans lequel il est imperméable aux lignes de champ, lorsque sa température est inférieure à sa température de transition supraconductrice, et inversement, de manière à engendrer des variations de champ magnétique dans le voisinage du corps, et des moyens de détection (3 ; 10, 11) de ces variations de champ, caractérisé en ce qu'il comporte des moyens de détermination du champ à partir de ces variations.

3.- Dispositif de mesure selon la revendication 2, caractérisé en ce que le corps (4) est disposé dans un cryostat (5), à une température inférieure à sa température de transition supraconductrice, et en ce qu'il comporte des moyens de chauffage (6, 7) du corps pour faire passer sa température au-dessus de sa température de transition supraconductrice.

4.- Dispositif de mesure selon la revendication 3, caractérisé en ce que les moyens de chauffage comprennent des moyens (6) de génération d'un rayonnement optique.

5.- Dispositif de mesure selon la revendication 4, caractérisé en ce que les moyens (6) de génération du rayonnement optique sont disposés à une extrémité d'un guide optique (7), à l'extérieur du cryostat (5), l'autre extrémité de ce guide étant disposée en regard du corps (4) dans le cryostat.

6.- Dispositif de mesure selon la revendication 5, caractérisé en ce que le guide optique comporte une fibre optique (7).

7.- Dispositif de mesure selon la revendication 5 ou 6, caractérisé en ce que les moyens (6) de génération du rayonnement optique comprennent une diode laser ou une diode électroluminescente.

8.- Dispositif de mesure selon l'une quelconque des revendications 2 à 7, caractérisé en ce que ledit corps (4) se présente sous la forme d une couche mince de matériau supraconducteur (8) disposée sur un substrat de matériau isolant (9), perpendiculairement aux lignes du champ.

9.- Dispositif de mesure selon la revendication 8, caractérisé en ce que la couche de matériau supraconducteur (8) présente une épaisseur comprise entre $10^{-2}$ $\mu$m et 10 $\mu$m, tandis que le substrat (9) présente une épaisseur comprise entre 0,1 $\mu$m et 10 $\mu$m.

10.- Dispositif de mesure selon la revendication 8 ou 9, caractérisé en ce que le corps se présente sous la forme d'un disque (13 ; 16).

11.- Dispositif de mesure selon la revendication 10, caractérisé en ce qu'un anneau (14) de matériau supraconducteur, de plus forte épaisseur que le disque (13), est disposé autour de celui-ci et est relié à celui-ci par des ponts (15).

12.- Dispositif de mesure selon la revendication 10 ou 11, caractérisé en ce que le disque (16) présente une nervure périphérique (17) en saillie sur au moins l'une de ses faces.

13.- Dispositif de mesure selon la revendication 10, 11 ou 12, caractérisé en ce que le disque présente un diamètre compris entre 1 mm et 30 mm.

14.- Dispositif de mesure selon l'une quelconque des revendications 2 à 13, caractérisé en ce que les moyens de détection des variations du champ comprennent au moins une spire (3 ; 10) de matériau conducteur ou supraconducteur, disposée autour du corps.

15.- Dispositif de mesure selon l'une quelconque des revendications 2 à 14, caractérisé en ce que les moyens de détermination du champ comprennent des moyens de mesure (11) d'une tension engendrée aux bornes des moyens de détection (3 ; 10) lors du passage du matériau supraconducteur entre ses deux états, cette tension étant proportionnelle au champ à mesurer.

FIG.1A

FIG.1B

FIG.2

FIG.3

FIG.4

FIG.5

FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | PATENT ABSTRACTS OF JAPAN vol. 4, no. 70 (P-12)(552), 23 mai 1980; & JP-A-5537979 (TOKYO SHIBAURA) 17.03.1980 * le document en entier * | 1-3,14, 15 | G 01 R 33/035 |
| A | idem | 10-13 | |
| A | PATENT ABSTRACTS OF JAPAN vol. 4, no. 70 (P-12)(552), 23 mai 1980; & JP-A-5537977 (TOKYO SHIBAURA) 17.03.1980 * le document en entier * | 1-3,10-15 | |
| A | REVIEW OF SCIENTIFIC INSTRUMENTS vol. 60, no. 2, février 1989, pages 202-208, New York, US; J.T. ANDERSON et al.: "Low-frequency noise reduction in SQUID measurement using a laser-driven superconducting switch. Part A: Direct input circuit switching" * page 202, colonne de droite, ligne 33 - page 203, colonne de gauche, ligne 8; figure 1 * | 4-9 | |
| A | PATENT ABSTRACTS OF JAPAN vol. 4, no. 70 (P-12)(552), 23 mai 1980; & JP-A-5537978 (TOKYO SHIBAURA) 17.03.1980 * le document en entier * | 1-3,10-13,14, 15 | DOMAINES TECHNIQUES RECHERCHES (Int. Cl.5)<br><br>G 01 R |
| P,Y | DE-A-3 843 087 (TDK) * colonne 1, lignes 53-66; figures 1,4 * | 1-3,14, 15 | |

Le présent rapport a été établi pour toutes les revendications

| Lieu de la recherche | Date d'achèvement de la recherche | Examinateur |
|---|---|---|
| BERLIN | 30-08-1990 | KEMPEN P J A X |